# EUROPEAN PATENT APPLICATION

(11) **EP 1 379 012 A1**
(43) Date of publication of application: **07.01.2004**
(21) Application number: 02014687.4
(22) Date of filing: 03.07.2002
(51) Int. Cl.: H04B 3/54, G01R 21/133

(54) **Integrated and automated water, gas and electricity meter reading via power line carrier**

(71) Applicant: Özalp, Aydin, 36043 Fulda (DE); Hun, Mücahit Özden, 62289 Darmstadt (DE)
(72) Inventor: Özalp, Aydin, 36043 Fulda (DE); Hun, Mücahit Özden, 62289 Darmstadt (DE)

(57) **Abstract**

The present invention *(The Minicom System)* relates to an automated and integrated *(power, gas and water meters are integrated into one module)* meter reading procedure and transfer of obtained digital data to a remote computer system *(utility company's substation)* by using Internet protocol and existing power line infrastructure. Therefore, *The Minicom System* combines successfully the following properties:
(1) replaces the analog power meter
(2) converses and stores digital data obtained from gas and water analog meters
(3) when demanded, processes and controls the stored information by using Internet protocol
(4) sends the data through a coupling element over the power line infrastructure to the utility companies' substation

The power, gas and water utility companies in return retrieve and process this information to build a database management (for example Oracle) for their billing procedure and other operational activities without having to refer to a site visiting.

## Description

The present invention ***(The Minicom System)*** relates to an automated and integrated *(power, gas and water meters are integrated into one module)* meter reading procedure and transfer of obtained digital data to a remote computer system *(utility company's substation)* by using Internet protocol and existing power line infrastructure. Therefore, ***The Minicom System*** combines successfully the following properties:
(1) replaces the analog power meter
(2) converses and stores digital data obtained from gas and water analog meters
(3) when demanded, processes and controls the stored information by using Internet protocol
(4) sends the data through a coupling element over the power line infrastructure to the utility companies' substation

The power, gas and water utility companies in return retrieve and process this information to build a database management (for example Oracle) for their billing procedure and other operational activities without having to refer to a site visiting.

### CONVENTIONAL PROCEDURE FOR THE METER READING

It has been for many years that the utility market has not changed its traditional approach in terms of providing power, gas and water supply to the consumers' homes and offices. As known, power, gas and water meters have been installed separately. Therefore, each utility company has to regularly (for example monthly or yearly) refer to a site visiting in order to obtain a meter reading. The utility companies will then handle the collected information in order to plan their billing procedure and other operations. But, this system has been proven to be costly and time consuming.

To illustrate better the conventional approach it will be appropriate to consider a power meter and its functions:

The electric current passes through a coil forming a magnetic force, which in return provokes a rotation movement on the analog counter. According to the intensity of current, the speed of rotation varies in direct proportion. A special gear system carries this mechanic movement to increase a decimal numeric counter accordingly. Thus, it is possible to obtain an analog reading on the counter. The utility companies' personnel visit regularly the site and read the analog counter to follow up the billing operations..

To alleviate this cumbersome procedure, some innovative companies have recently introduced "electronic" power meters. By using radio frequency or telephone line communication, it has been possible to transfer the data to the utility center. But, because of the following reasons, this system also has been proven to be costly and not convenient.
*(1)* Telephone line communication (Internet) is expensive and limited *(compared to power line carrier)*
(2) The meters are generally installed in the hidden part of the buildings therefore it is difficult to obtain a complete and accurate reading by using radio frequency.
*(3)* Electronic meters find their application only in the power meters. *(Gas and water meters are left out of the technological innovations)*
*(4)* Radio frequency based electronic meters requires partial site visiting as well

### THE CONCEPT OF The Minicom System

With insight and innovation we have designed ***The Minicom System*** to integrate power, gas and water meter readings into one module and transfer the digitized data over the existing power line infrastructure (PLC) to the utility companies' substation. Thus, operating expenses related to meter readings are considerably reduced. Moreover, an effective data bank is built to break down all sort of information for a better management of the utility market.

***The Minicom System*** module replaces the existing analog power meter completely. It is in the size of about a DIN A4 page. As a part of its operation, two separate analog/digital adapters are installed on the water and gas meters in order to convert and carry the analog counter information in digitized form to ***The Minicom System****.*

Meter reading with ***The Minicom System*** is all about communication that conveys information from thousands of separate locations (end user) to one location (the utility office). Generic term for this operation is called Automated Meter Reading (AMR). The AMR systems are classified by which technology use to communicate. Three most popular are telephone (internet), radio and power line carrier (PLC). ***The Minicom System*** uses existing power line infrastructure (PLC) to communicate with the substations. Information arrives from every meter every day (or as often as desired) to be used in a wide variety of utility operations, from load management to maintenance planning and to billing. To this end ***The*** ***Minicom System*** uses an Internet protocol (for example TCP/IP) and an operating system (for example Linux ) to achieve its goals.

Engineers use the data to balance loads and identify outages and failing equipment. Continuos flow of the information from the meters telling each customer's kWh usage, peak demand, time and date of peak, whether or not there is a tampering

Each utility company has their favorite billing and operation software. With ***The Minicom System,*** it will be possible to standardize and harmonize the whole operating activities, which will increase considerably the competitive spirit in the utility market.

### AIM OF THE INVENTION

Our invention will change drastically the meter-reading applications and revolutionize the utility market. We expect that ***The Minicom System*** *will* introduce the following advantage on behalf of consumers and utility companies:
1. Integrates three meter-reading activities (so far each utility company -power, gas and water- has to undertake meter reading procedure separately) and eliminates the need to a site visiting
2. Sends the data cost-effective way over the existing power lines infrastructure (PLC)
3. Improves customer relations and provides data to plan a detailed billing procedure
4. Deters meter tampering and detects whether a customer is connected or not
5. Provides continuos power consumption data to create customer usage profiles
6. Helps to determine minimum and maximum demand for the effective load management
7. Helps utility companies to choose convenient price in the competitive market and to declare a consumption value relating to time frame
8. Makes it possible to control power, gas or water usage with remote on/off switching capability in case if a billing dispute arises, or to sell the power in advance to help end users to plan their consumption as they desire.
9. Introduces an effective standardization procedure and contributes to environmental protection.

### BRIEF DESCRIPTION OF THE DRAWINGS

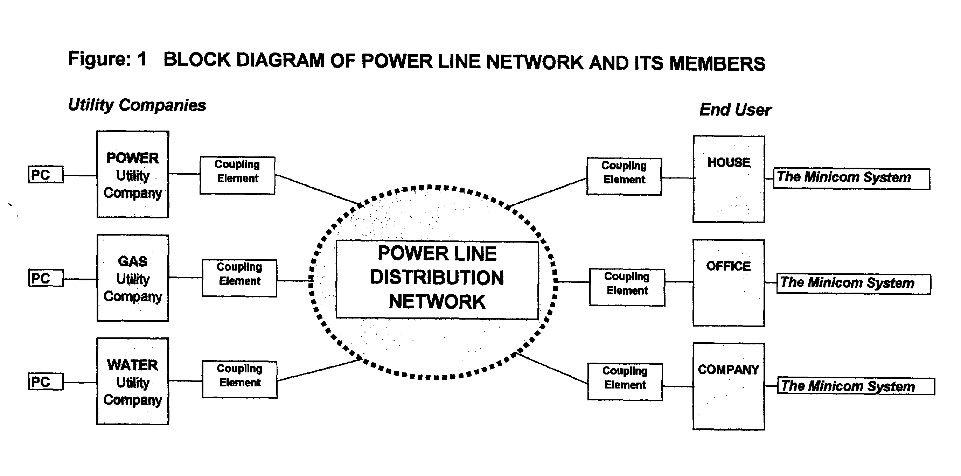

**Figure 1** is a block diagram of power, gas and water distribution network which links end users with utility companies. As shown, each end user's ***The Minicom System*** is connected to the substation through a coupling element.

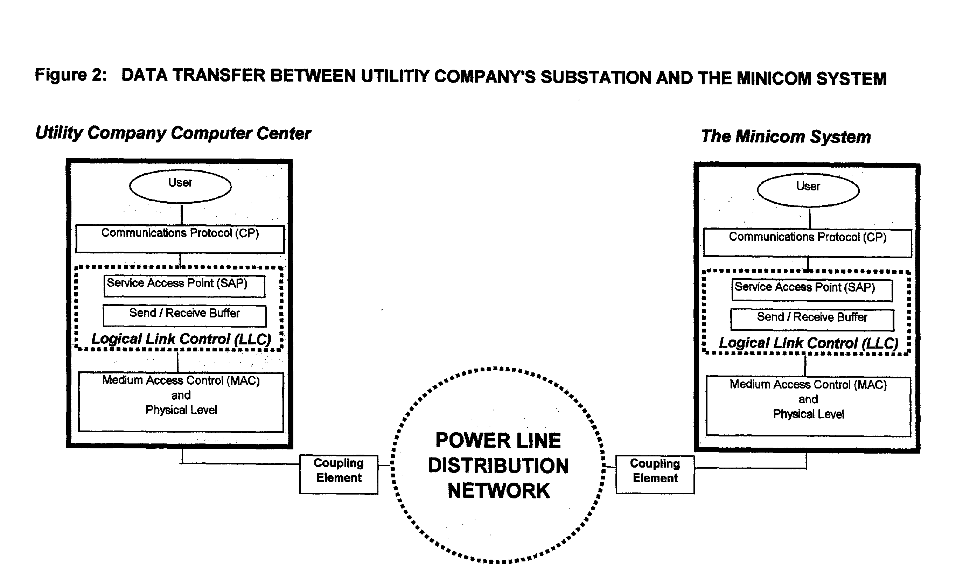

**Figure 2** represents an example of how ***The Minicom System*** communicates with the utility company's remote substation.

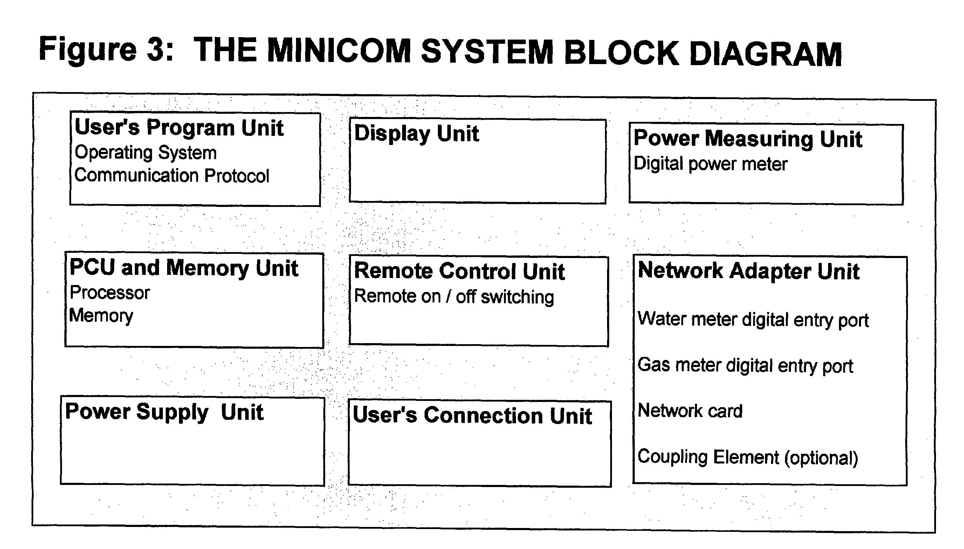

**Figure 3** represents an example of ***The Minicom System's*** circuit board and its various major components controlling its operations.

## Claims

1. The existing technology and procedure of meter reading mostly done with analog devices, therefore is not possible to build a databank to break down the information into parts. In order to obtain a meter reading, utility personnel have to refer to a site visiting, which is slow, costly and time-consuming.

2. ***The Minicom System*** overcomes not only the above mentioned operational difficulties with an integrated meter reading procedure and communication system, but also supplies enormous information to improve the working condition of the utility market fundamentally.

3. ***The Minicom System*** comprises a magnetic current sensor which helps capture power consumption in terms of digital data *(Power Measuring Unit).*

4. ***The Minicom*** *System* as in Claim 3, further comprising an entry port carrying the digital data coming from the gas meter *(Network Adapter Unit).*

5. *The Minicom System* as in Claim 3 and 4, further comprising a communication port carrying the digital data coming from the water meter *(Network Adapter Unit).*

6. ***The Minicom*** *System* as in Claim 3, 4 and 5, further comprising a coupling element (optional) to transfer the data over the power line *(Network Adapter Unit).*

7. ***The Minicom System*** as in Claim 3, 4, 5 and 6, further comprising an operating system and communication protocol *(Program Unit).*

8. ***The Minicom System*** as in Claim 3, 4, 5, 6 and 7, further comprising a processor and memory *(PCU and Memory Unit).*

9. *The Minicom System* as in Claim 3, 4, 5, 6, 7 and 8, further comprising a Power Supply Unit.

10. ***The Minicom System*** as in Claim 3, 4, 5, 6, 7, 8 and 9, further comprising a Display Unit

11. ***The Minicom System*** as in Claim 3, 4, 5, 6, 7, 8, 9 and 10, further comprising a Remote Control Unit.

12. ***The Minicom System*** as in Claim 3, 4, 5, 6, 7, 8, 9, 10 and 11, further comprising a User's Connection Unit.
